# EUROPÄISCHE PATENTANMELDUNG

(11) **EP 0 955 391 A2**
(43) Veröffentlichungstag der Anmeldung: **10.11.1999**
(21) Anmeldenummer: 99102184.1
(22) Anmeldetag: 04.02.1999
(51) Int. Cl.: C23C 14/04

(54) **Musterträger**

(30) Priorität: 02.05.1998 DE 19819672
(71) Anmelder: Balzers und Leybold Deutschland Holding Aktiengesellschaft, 63450 Hanau (DE)
(72) Erfinder: Achtner, Wolfgang, 63477 Maintal (DE); Oberle, Klaus, 63768 Hösbach (DE); Winter, Erwin, 63456 Hanau (DE); Sauer, Petra, 63768 Hösbach (DE); Neudert, Hans, 63579 Freigericht (DE); Vogt, Thomas, 63538 Grosskrotzenburg (DE); Klemm, Günter, 63667 Nidda (DE); Hoffmann, Gerd, 63486 Bruchköbel (DE)

(57) **Zusammenfassung**

Um einen Walzenkörper, der insbesondere bei einer Vorrichtung zum Erzeugen von Mustern unter Aufbringen eines gasförmigen Mediums auf einem insbesondere bandförmigen Substrat (1) einsetzbar ist, bereitzustellen, der mit einem an dem Walzenkörper ausgebildeten Vertiefungsmuster versehen ist, mit welchem eine wesentlich gesteigerte Menge an gasförmigem Medium bevorratet werden und unter Abwalzen als Flüssigkeitsfilm am Substrat (1) kondensieren kann, ist vorgesehen, daß das Vertiefungsmuster einen Boden (7) aufweist, der eine gegenüber der mit dem Substrat (1) in Kontakt tretenden Oberfläche erhöhte Aufnahmefähigkeit für das Gasmedium aufweist.

## Beschreibung

Die Erfindung betrifft einen Musterträger, insbesondere für den Einsatz in einer Vorrichtung zum Erzeugen von Mustern auf einem insbesondere bandförmigen Substrat unter stellenweisem Aufbringen eines eine nachfolgende Beschichtung verhindernden gasförmigen Mediums nach dem Oberbegriff des Anspruchs 1.

Derartige zumeist als Druckwalze ausgebildete Musterträger werden beispielsweise bei der Herstellung bzw. Weiterbehandlung von Kondensatorfolien verwendet. Das gasförmige Medium kondensiert hierzu an der Folienoberfläche und bildet einen Flüssigkeitsfilm mit vorbestimmten Muster aus. Bei der weiteren Verarbeitung des Substrates können somit zusätzliche auf das Substrat aufzubringende Substanzen an den Stellen, an welchen der Flüssigkeitsfilm ausgebildet ist, abgewiesen werden.

Ein solches Verfahren sowie eine Vorrichtung mit einem als Walzenkörper ausgebildeten Musterträger der gattungsbildenden Art ist in der deutschen Offenlegungsschrift DE-A-4 310 085 offenbart, auf deren Inhalt vollumfänglich Bezug genommen wird.

Gemäß DE-A-4 319 085 werden mit dem Verfahren Kunststoffolien mit Partien beliebiger Konfiguration beschichtet, wobei die metallisierten Partien eine hohe Konturenschärfe aufweisen und die Gefahr ausgeschlossen ist, daß Benetzungsmittel auf die zu beschichtenden Partien beispielsweise kriecht. Hierzu wird unter anderem ein rotierender Walzenkörper verwendet, der an der Oberfläche Nuten in Form des geforderten Musters, wie es als Flüssigkeitsfilm auf dem Substrat entstehen soll, aufweist.

Ein Teil des Umfanges des Walzenkörpers befindet sich dazu in einer abgeschlossenen Kammer, in welcher die Substanz, welche den Film bilden soll, verdampft wird. Der Dampf, insbesondere ein Öldampf, verteilt sich in der Kammer und gelangt somit auch in die Nuten des Walzenkörpers. Durch Drehung der Walzenkörper gelangen die mit Dampf gefüllten Nuten in den Bereich außerhalb der Kammer. Dort wird das Substrat in wesentlichem synchron an dem Walzenkörper entlanggeführt und mit dessen Oberfläche auf einer ausreichenden Fläche in Kontakt gebracht, so daß der in den Nuten vorhandene Dampf an dem Substrat kondensiert und einen der Form der Nut entsprechenden Film bildet.

Um die Nuten an dem Walzenkörper, der im wesentlichen einen Messingkern aufweist, auszubilden, beschreibt DE-A-4 310 085 zwei verschiedene Vorgehensweisen. Einerseits ist es möglich, zunächst eine zusätzliche Kupferschicht auf den Messingkern aufzubringen, in welche anschließend durch Ätzen die Nuten einzubringen sind. Als weitere Möglichkeit wird das Fräsen der Nuten in den Messingkern vorgeschlagen. Beiden Vorgehensweisen ist gemeinsam, daß im Anschluß der Walzenkörper mit einer Hartverchromung versehen wird, um die mit dem Substrat in Kontakt tretende Oberfläche verschleißfest zu machen.

Von Nachteil bei diesem Walzenkörper ist jedoch, daß nur eine sehr geringe und auf vielen Anwendungsgebieten keine ausreichende Bevorratung der Nuten mit Dampf ermöglicht wird. Denn in Folge einer zu geringen, in den Nuten jeweils befindlichen Dampfmenge ist der durch Kondensation an dem Substrat aufgebrachte Film unzureichend. Das Ergebnis der nachfolgenden Bearbeitungsschritte, und damit die Qualität des hergestellten Endproduktes wird dadurch negativ beeinflußt.

Aufgabe der Erfindung ist es, einen Musterträger der gattungsbildenden Art bereitzustellen, der ein daran ausgebildetes Vertiefungsmuster aufweist, mit welchem eine wesentlich gesteigerte Menge eines zum Benetzen des Substrats vorgesehenes Medium bevorratet werden und somit als Flüssigkeitsfilm am Substrat kondensieren kann.

Die erfindungsgemäße Lösung der Aufgabe ist auf höchst überraschende Weise bereits durch die Merkmale des Anspruchs 1 gekennzeichnet.

Durch Ausbilden eines Vertiefungsmuster an dem Musterträger mit einem Bodenbereich, der eine gegenüber der mit dem Substrat in Kontakt tretenden Oberfläche des Musterträgers erhöhte Aufnahmefähigkeit für das Medium aufweist, kann jede einzelne der das Vertiefungsmuster ausbildende Nut eine größere Dampfmenge aufnehmen.

Durch diese erfindungsgemäße Ausbildung wird die aufgenommene Dampfmenge und somit die für die Bildung der Filmschicht an dem Substrat nutzbare Menge an kondensierender Flüssigkeit bedeutend erhöht. Dadurch kann ferner die Dicke und Gleichmäßigkeit des auf das Substrat aufgebrachten Films in besonders vorteilhafter Weise erhöht werden. Da hierdurch die Konturengenauigkeit mittels der mit dem Substrat in Kontakt tretenden Oberfläche nicht beeinflußt wird, wirkt sich die Maßnahme insgesamt in höchst positiver Weise auf die Qualität des jeweiligen Endproduktes aus.

In besonders bevorzugter Ausgestaltung ist vorgesehen, einen als Druckwalze ausgebildeten Musterträger zu verwenden, auf dessen im wesentlichen zylindrischen Kern eine erste, poröse Schicht aufgebracht ist, auf welcher dann eine zweite, dem Vertiefungsmuster entsprechende Deckschicht ausgebildet ist. In Folge der porösen Feinstruktur der den Boden des Vertiefungsmusters bildenden ersten Schicht entsteht eine Kapillarwirkung, durch die die Aufnahmefähigkeit jeder einzelnen Nut für Dampf wesentlich gesteigert werden kann.
In der Praxis hat sich für die Nutzung als poröse Schicht eine auf dem Walzenkern aufgetragene Schicht aus Oxidkeramik oder auch aus gesintertem Metallpulver als besonders geeignet erwiesen. Für die Deckschicht hat sich ein insbesondere galvanisch auftragbares, ätzbares Material, wie beispielsweise Kupfer oder Nickel, als vorteilhaft erwiesen, um auf einfache und kostengünstige Weise ein Vertiefungsmuster in der Deckschicht ausbilden zu können.

Als Alternative zu einem Musterträger, der ein Vertiefungsmuster aufweist, das in einer zusätzlich auf den Kern aufgetragenen Schicht ausgebildet ist, hat sich ferner ein Musterträger bewährt, an dessen Kern zunächst das Vertiefungsmuster, zum Beispiel mittels Fräs- und/oder Gravurtechniken hergestellt, und an welchem dann unter Ausnutzung anodischer Oxidation eine Oxidschicht aufbringbar ist.

Um einer vorzeitigen Abnutzung vorzubeugen, weist der erfindungsgemäße Musterträger vorteilhafterweise eine harte, verschleißfeste, insbesondere eine Chromverbindung umfassende, Oberflächenschicht auf.

In weiterer vorteilhafter Ausgestaltung umfaßt der Walzenkern ein Material höherer Wärmeleitzahl, um sowohl bei Aufnahme des gasförmigen Mediums im Vertiefungsmuster als auch bei der Kondensation des Mediums am Substrat eine schnelle thermische Anpassung der entsprechenden Kernbereiche zu gewährleisten. In der Praxis haben sich insbesondere Materialien wie Aluminium, eine Aluminiumlegierung oder auch Messing als geeignet erwiesen.

Darüber hinaus haben sich in der Praxis Vertiefungsmuster mit Nutbreiten im Bereich von 0,3 mm bis 0,5 mm sowie Nuttiefen von wenigstens 0,3 mm besonders bewährt.

Die Erfindung wird nachfolgend anhand zweier bevorzugter Ausführungsformen unter Bezugnahme auf die beigefügten Zeichnungen beispielhaft beschrieben.

Es zeigen:
- Fig. 1: eine schematische Darstellung einer Vorrichtung zum Erzeugen von Mustern unter Aufbringen eines gasförmigen Mediums auf einem Substrat, mit einem daran angeordneten Walzenkörper,
- Fig. 2: einen Schnitt durch einen Teilbereich einer ersten erfindungsgemäßen Ausführungsform des Walzenkörpers nach Fig. 1, und
- Fig. 3: einen Schnitt durch einen Teilbereich einer zweiten erfindungsgemäßen Ausführungsform des Walzenkörpers nach Fig. 1.

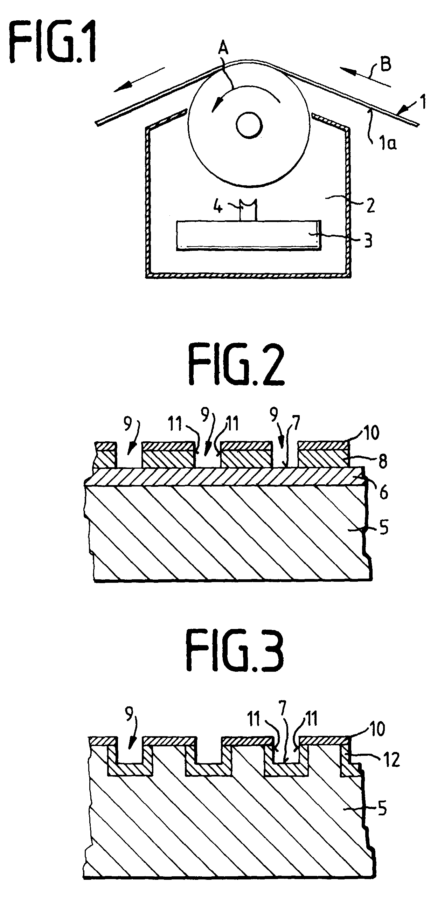

Nachfolgend wird zunächst auf Fig. 1 Bezug genommen, welche skizzenhaft eine Vorrichtung zum Erzeugen von Mustern unter Aufbringen eines gasförmigen Mediums auf einem Substrat 1 mit einem daran angeordneten Walzenkörper darstellt.

Wie Fig. 1 zu entnehmen ist, ist der Walzenkörper drehbar angeordnet, wobei dessen jeweils untere Umfangsbereich eine im wesentlichen dichte Druckkammer 2 durchläuft. Innerhalb der Kammer 2 befindet sich eine Verdampfereinrichtung 3 mit einer Düse 4, aus der ein gasförmiges Medium, insbesondere ein Öldampf unter Einsatz an sich bekannter Techniken verdampft. Die Verdampfereinrichtung 3 mit der Düse 4 sind in Bezug auf den Walzenkörper so angeordnet, daß das Medium senkrecht zur Oberfläche des Walzenkörpers verdampft und somit von einem an dem Walzenkörper ausgebildeten Vertiefungsmuster aufgenommen wird. Durch Drehung des Walzenkörper in Pfeilrichtung A gelangen jeweils mit Dampf gefüllte Bereiche des Vertiefungsmusters außerhalb der Kammer 2 und treten in Kontakt mit dem über den Walzenkörper in Pfeilrichtung B geführten bandförmigen Substrat 1. In Folge der damit verbundenen Abkühlung außerhalb der Kammer 2 kondensiert der im Vertiefungsmuster bevorratete Dampf an der Substratoberfläche 1a, so daß daran ein dem Vertiefungsmuster entsprechender Beschichtungsfilm aufgebracht wird. Es sei erwähnt, daß die erzielte Konturengenauigkeit des am Substrat 1 abgelagerten Films entsprechend der Oberflächengüte der mit dem Substrat 1 in Kontakt tretenden Walzenkörperoberfläche zunimmt.

Für eine eingehende Beschreibung einer derartigen Pattern-Verdamfer-Vorrichtung wird vollumfänglich auf die deutsche Offenlegungsschrift DE-A-4 310 085 verwiesen.

Fig. 2 zeigt schematisch den Querschnitt durch einen äußeren Teilbereich des Walzenkörper nach Fig. 1 in einer ersten erfindungsgemäßen Ausführungsform.

Der Walzenkörper umfaßt einen metallischen Kern 5 mit guten Wärmeleitungseigenschaften, um sowohl ein schnelles Aufwärm- als auch Abkühlverhalten der Außenbereiche des Kerns 5 bei der Dampfaufnahme bzw. für die Kondensation des Dampfes am Substrat 1 zu gewährleisten. Hierzu haben sich Kernmaterialien aus Aluminium, einer Aluminiumlegierung oder auch Messing bewährt.

Auf den Kern 5 ist eine erste Schicht 6 aufgebracht, welche den Boden 7 des Vertiefungsmusters ausbildet. Um eine erhöhte Aufnahmefähigkeit für dem Dampf zu erzielen, ist die Schicht 6 als poröse Schicht ausgebildet, die beispielsweise Oxidkeramik oder gesintertes Metallpulver enthält.

Die Porengröße soll dabei zweckmäßiger Weise etwa 10 µm betragen, um eine besonders vorteilhafte kapillare Wirkung zu erreichen. Auf dieser porösen Schicht 6 ist eine Schicht 8 aufgetragen, deren Dicke der Tiefe des Vertiefungsmuster entspricht. Die Schicht 8 weist gut ätzbares Material, wie Kupfer oder Nickel auf, so daß nach dem Aufbringen der Schicht 8 ein gewünschtes Vertiefungsmuster einfach z.B. durch einen lithografischen Ätzprozeß des Beschichtungsmaterials herstellbar ist. Für die einzelnen, das Vertiefungsmuster insgesamt definierenden Nuten 9 haben sich Breiten von 0,3 mm bis 0,5 mm als zweckmäßig erwiesen.

Auf die zwischen den einzelnen Nuten 9 stehengelassenen Abschnitte der Schicht 8 ist in einem im wesentlichen abschließenden Produktionsschritt eine Schutzschicht 10 aus einer Chromverbindung aufgebracht, welche die darunterliegende, das Vertiefungsmuster ausbildende Schicht 8 vor einer vorzeitigen Abnutzung im Betrieb des Walzenkörpers in Folge eines wiederholten Inkontakttretens mit dem Substrat 1 schützt. Die Schutzschicht 10 weist hierzu etwa eine Stärke von 1 µm bis 5 µm auf und ist mittels Aufsputterung hergestellt.

Die seitlichen Innenflächen 11 der Nuten 9 sowie der Boden 7 des Vertiefungsmusters bleiben von dieser Schutzschicht 10 ausgespart.

Fig. 3 stellt eine alternative Ausführungsform dar, wobei auch hier von einem entsprechenden metallischen Kern 5 ausgegangen wird. Der Walzenkern 5 weist wie der der Fig. 2 einen Durchmesser in der Größenordnung von 80 mm auf.

In Abwandlung zu Fig. 2 ist das Vertiefungsmuster bzw. sind die Nuten 9 in den Kern 5 durch chemisches Ätzen eingebracht. Aber auch andere Verfahren, wie z. B. Laserstrahlätzen oder Gravurtechniken sind zum Ausbilden des Vertiefungsmusters anwendbar. Die Abmessungen der Nuten 9 sowie die Tiefe des Vertiefungsmusters sind denen gemäß Fig. 2 vergleichbar.

Nach dem Ausbilden des Vertiefungsmusters ist der Walzenkörper einer anodischen Oxidation unterzogen worden, um am äußeren Bereich des Kerns 5 eine Oxidschicht 12 auszubilden. Hierdurch zeigt nicht nur der Boden 7 des Vertiefungsmusters, sondern zusätzlich die seitlichen Innenflächen 11 der Nuten 9 eine erhöhte Dampfaufnahmefähigkeit.

Um zu gewährleisten, daß für die geforderte Konturengenauigkeit des Beschichtungsfilms die mit dem Substrat 1 in Kontakt tretende Oberfläche des Walzenkörpers auch bei vorheriger anodischer Oxidation des Walzenkörper wieder eine Oberfläche hoher Güte erhält, muß die Oxidschicht 12 an diesen Bereichen durch einen anschließenden Schleifvorgang wieder geglättet werden.

Dies kann durch einfaches Überschleifen der Walzenkörperaußenflächen bis auf die gewünschte Güte erfolgen.

Ferner kann jedoch die Oxidschicht 12 an der Oberfläche erst abgeschliffen und anschließend eine feste widerstandsfähige Oberschicht 10, insbesondere aus einer Chromverbindung durch Aufsputtern auf der Außenfläche des Walzenkörper aufgebracht werden. Diese Schicht 10 hat sich wiederum mit einer Stärke von 1 µm bis 5 µm als ausreichend erwiesen.

Die beiden vorstehend beschriebenen Ausführungsformen und Abmessungen der Walzenkörper sind für die spezielle Anwendung der Vorbehandlung von Folien für elektrische Kondensatoren vor der Aufbringung der Metallisierung der Kondensatorflächen ausgelegt, so daß nicht zu metallisierende Flächen aufgrund des aufgebrachten Filmes ausgespart werden.

Es sei jedoch darauf hingewiesen, daß die für den Einsatz bei der Herstellung von Kondensatorfolien beschriebenen Ausführungen der Walzenkörper durch Variationen von Aufbau und Abmessungen auch in anderen Anwendungsbereichen, in welchen eine Behandlung von Substraten erfolgt, eingesetzt werden können. Als ein Beispiel wird auf die Verwendung in der Verpackungsindustrie verwiesen.

## Patentansprüche

1. Musterträger, insbesondere für den Einsatz in einer Vorrichtung zum Erzeugen von Mustern auf einem insbesondere bandförmigen Substrat (1) unter stellenweisem Aufbringen eines eine nachfolgende Beschichtung des Substrats verhindernden und dieses benetzende Medium, mit einem vorbestimmten Vertiefungsmuster zur Aufnahme des gasförmigen Mediums, wobei der Musterträger synchron mit dem Substrat (1) bewegbar ist und mit diesem in Kontakt tritt, **dadurch gekennzeichnet, daß** das Vertiefungsmuster einen Bodenbereich (7) aufweist, der eine gegenüber der mit dem Substrat (1) in Kontakt tretenden Oberfläche des Musterträgers erhöhte Aufnahmefähigkeit für das gasförmige Medium besitzt.

2. Musterkörper nach Anspruch 1, **dadurch gekennzeichnet, daß** der Musterträger als Druckwalze ausgebildet ist und einen zylindrischen Kern (5) aufweist, auf den eine poröse Schicht (6) aufgebracht ist, auf welcher wiederum eine dem Vertiefungsmuster entsprechende Deckschicht (8) ausgebildet ist.

3. Musterträger nach Anspruch 2, **dadurch gekennzeichnet, daß** die poröse Schicht (6) eine poröse Oxidkeramik oder gesintertes Metallpulver umfaßt.

4. Musterträger nach Anspruch 2 oder 3, **dadurch gekennzeichnet, daß** die Deckschicht (8) aus einem ätzbaren Material hergestellt ist.

5. Musterträger nach Anspruch 1, dadurch gekennzeichnet, daß der Musterträger als Druckwalze ausgebildet ist und einen zylindrischen Kern (5) aufweist, in welchem das Vertiefungsmuster bildende Nuten (9) eingebracht sind, und daß auf dem Musterträger mittels anodischer Oxidation eine die Nuten bedeckende Oxidschicht (12) aufbringbar ist.

6. Musterträger nach einem der Ansprüche 2 bis 5, **dadurch gekennzeichnet, daß** auf der Deckschicht (8) bzw. der Oxidschicht (12) eine dem Vertiefungsmuster entsprechende Oberschicht (10) ausgebildet ist.

7. Musterträger nach einem der vorstehenden Ansprüche**, dadurch gekennzeichnet, daß** der Musterträger einen metallischen, insbesondere Aluminium, eine Aluminiumlegierung oder Messing umfassenden Kern (5) aufweist.

8. Musterträger nach einem der vorstehenden Ansprüche, **dadurch gekennzeichnet, daß** der Musterträger einen Kern (5) mit hoher Wärmeleitzahl umfaßt.

9. Musterträger nach einem der vorstehenden Ansprüche, **dadurch gekennzeichnet, daß** die das Vertiefungsmuster bildenden Nuten jeweils eine Breite von etwa 0,3 mm bis 0,5 mm sowie eine Tiefe von wenigstens 0,3 mm aufweisen.
